# EUROPÄISCHE PATENTSCHRIFT

(11) **EP 0 960 342 B1**
(45) Veröffentlichungstag und Bekanntmachung des Hinweises auf die Patenterteilung: **22.01.2003**
(21) Anmeldenummer: 98910608.3
(22) Anmeldetag: 11.02.1998
(51) Int. Cl.: G01R 15/18, G01R 19/20

(54) **STROMSENSOR MIT SELBSTSCHWINGENDER GENERATORSCHALTUNG**
CURRENT SENSOR WITH SELF-OSCILLATING GENERATOR CIRCUIT
DETECTEUR DE COURANT AVEC CIRCUIT GENERATEUR AUTO-OSCILLANT

(30) Priorität: 14.02.1997 DE 19705770
(43) Veröffentlichungstag der Anmeldung: 01.12.1999
(73) Patentinhaber: Vacuumschmelze GmbH, 63450 Hanau (DE)
(72) Erfinder: LENHARD, Friedrich, D-63452 Hanau (DE)
(74) Vertreter: Patentanwälte Westphal, Mussgnug & Partner
(86) Internationale Anmeldenummer: DE9800381
(87) Internationale Veröffentlichungsnummer: WO98036283

(56) Entgegenhaltungen:
- PATENT ABSTRACTS OF JAPAN vol. 010, no. 019 (P-423), 24.Januar 1986 -& JP 60 173475 A (MISHIMA KOUSAN KK), 6.September 1985,
- PATENT ABSTRACTS OF JAPAN vol. 010, no. 052 (P-432), 28.Februar 1986 & JP 60 196678 A (MISHIMA KOUSAN KK), 5.Oktober 1985,
- PATENT ABSTRACTS OF JAPAN vol. 010, no. 019 (P-423), 24.Januar 1986 & JP 60 173476 A (MISHIMA KOUSAN KK), 6.September 1985,

## Beschreibung

Die Erfindung betrifft einen Stromsensor mit einem Magnetkern, auf dem neben einer Primärwicklung, in der der zu messende Strom fließt, mindestens eine Sekundärwicklung aufgewickelt ist, in die ein durch eine selbstschwingende Generatorschaltung erzeugter Wechselstrom eingespeist wird, der den Magnetkern abwechselnd in mindestens einer Richtung sättigt, wobei die Polarität des von der Generatorschaltung erzeugten Wechselstroms in Abhängigkeit von dem in der Sekundärwicklung fließenden Strom und mindestens einem Schwellenwert für diesen Strom wechselt.

Ein solcher Stromsensor ist zum Beispiel aus der japanischen Patentanmeldung JP-A-60173475 bekannt, wobei ein Operationsverstärker zusammen mit einer Primär- und zwei Sekundärwicklungen eine selbstschwingende Generatorschaltung bildet. Zudem sind in den japanischen Patentanmeldungen JP-A-60196678 und JP-A-60173476 selbstschwingende Generatorschaltungen mit Operationsverstärkern beschrieben.

In der DE 42 29 948 A1 ist ein Stromsensor beschrieben, bei dem ein weichmagnetischer Magnetkern mit einer Primär- und einer Sekundärwicklung vorgesehen ist. In Reihe zu der Sekundärwicklung ist eine zusätzliche Stromquelle geschaltet, die durch die Sekundärwicklung einen Magnetisierungsstrom schickt, der den weichmagnetischen Magnetkern abwechselnd in die positive bzw. negative Sättigung steuert. Der weichmagnetische Magnetkern besitzt eine im wesentlichen rechteckförmige Magnetisierungskennlinie, so daß während der Ummagnetisierung zwischen zwei Sättigungszuständen ein jeweils konstanter Strom fließt, da in Folge des nahezu senkrechten Verlaufs der Magnetisierungskennlinie der induktive Widerstand gegen unendlich geht. Dieser Strom unterscheidet sich in der positiven bzw. negativen Halbwelle von einem Mittelwert jeweils durch einen Wert, der durch die Hysterese der Magnetisierungskennlinie gegeben ist. Durch Mittelwertbildung des während der Ummagnetisierung fließenden konstanten Stroms bei zwei aufeinanderfolgenden Halbwellen mit unterschiedlicher Polarität läßt sich der Einfluß der Hysterese in der Magnetisierungsschleife kompensieren, so daß die Messung des während der Ummagnetisierungszeit des Magnetkerns fließenden Stromes in der Sekundärwicklung einen Strom ergibt, der direkt proportional dem zu messenden Strom in der Primärwicklung ist. Zum Erreichen einer bestimmten Genauigkeit ist jedoch ein verhältnismäßig hoher schaltungstechnischer Aufwand notwendig.

Aufgabe der Erfindung ist es daher, einen Stromsensor anzugeben, der bei gleicher Genauigkeit einen geringeren Aufwand bzw. bei gleichem Aufwand eine höhere Genauigkeit bietet.

Die Aufgabe wird durch einen Stromsensor gemäß Patentanspruch 1 gelöst. Ausgestaltungen und Weiterbildungen des Erfindungsgedankens sind Gegenstand von Unteransprüchen.

Erfindungsgemäß wird bei einem Stromsensor der eingangs genannten Art die Aufgabe dadurch gelöst, daß die Generatorschaltung zur Erzeugung des Wechselstroms selbstschwingend ist, wobei die Polarität des von der Generatorschaltung erzeugten Wechselstroms in Abhängigkeit von dem in der Sekundärwicklung fließenden Stromes und mindestens einem Schwellenwert für diesen Stromwechsel. Dabei wird die Nichtlinearität der Kennlinie des Magnetkernwerkstoffes elektronisch ausgenutzt, indem Schaltschwellwerte definiert werden, die elektronisch die Polarität des Wechselstromes umschalten. Die Schleifenform, der Wert der Sättigung und in bestimmtem Maße auch die Hysterese des Magnetkernwerkstoffes sind dabei von nur untergeordneter Bedeutung.

Bei einer bevorzugten Ausführungsform eines erfindungsgemäßen Stromsensors ist vorgesehen, daß die Generatorschaltung eine Reihenschaltung zweier invertierender Verstärker (z.B. Inverter, logische Gatter, invertierende Schaltverstärker, Komparatoren etc.) aufweist, wobei die Sekundärwicklung über einen ersten Widerstand zwischen Eingang und Ausgang des einen Verstärkers geschaltet ist und der Eingang des einen Verstärkers zudem mit dem Ausgang des anderen Verstärkers gekoppelt ist. Ein pulsweitenmoduliertes Ausgangssignal steht an den Ausgängen beider Verstärker bereit und kann dort jeweils abgenommen werden. Bei dieser Ausführungsform wird die Sekundärwicklung mit einer Rechteckspannung angesteuert, die dann umgeschaltet wird, wenn der Strom durch die Sekundärwicklung einen bestimmten Wert übersteigt. Je nach Größe des zu messenden Stromes ist die Kennlinie verschoben. Folglich sind positive und negative Halbwelle nicht mehr gleich groß. Damit verändert sich jedoch das Pulsbreitenverhältnis des Ausgangssignals, das für sich oder aber als Signalmittelwert ausgewertet werden kann.

Bei einer anderen bevorzugten Ausführungsform ist die Generatorschaltung derart ausgebildet, daß ein zweiter Widerstand zwischen einen ersten Knotenpunkt und einen ersten Anschluß der Sekundärwicklung und ein dritter Widerstand zwischen einen zweiten Knotenpunkt und einen zweiten Anschluß der Sekundärwicklung geschaltet ist. Der zweite Anschluß der Sekundärwicklung ist mit einem Eingang eines ersten NAND-Gatters und unter Zwischenschaltung eines ersten Inverters mit einem Eingang eines NOR-Gatters verbunden. Dabei sind jeweils ein zweiter Eingang des ersten NAND-Gatters und ein zweiter Eingang des NOR-Gatters mit dem zweiten Knotenpunkt verschaltet. Weiterhin ist ein Eingang eines zweiten NAND-Gatters mit dem ersten Anschluß der Sekundärwicklung und dessen zweiter Eingang mit dem Ausgang des ersten NAND-Gatters verbunden. Schließlich sind die Ausgänge von NOR-Gatter und erstem NAND-Gatter mit den Eingängen eines AND-Gatters gekoppelt, dessen das pulsmodulierte Ausgangssignal führender Ausgang mit dem zweiten Knotenpunkt direkt und mit dem ersten Knotenpunkt unter Zwischenschaltung eines zweiten Inverters verbunden ist. Bei dieser Ausführungsform wird nur eine der beiden Schaltflanken ausgenutzt, wodurch vorteilhafterweise ein hoher Offset, der durch die unterschiedlichen Schaltpegel bei positiver und negativer Schaltflanke entsteht, vermieden wird.

Weiterhin kann vorgesehen werden, daß jeweils zwischen erstem Knotenpunkt und erstem Anschluß der Sekundärwicklung sowie zwischen zweitem Knotenpunkt und zweitem Anschluß der Sekundärwicklung jeweils eine Freilaufdiode geschaltet ist.

Bei einer Weiterbildung der Erfindung wird jeweils ein Kondensator in Reihe zu erstem und zweitem Widerstand geschaltet. Dadurch wird die Sekundärwicklung anstelle einer Rechteckspannung mit einer angenähert sägezahnförmigen Spannung angesteuert, wodurch die Empfindlichkeit der Sensorkennlinie erhöht wird.

Bevorzugt wird dabei zwischen den zweiten Eingang des ersten NAND-Gatters und den zweiten Knotenpunkt ein Tiefpaß geschaltet. Außerdem kann ein Eingang des zweiten NAND-Gatters über einen vierten Widerstand mit dem ersten Anschluß der Sekundärwicklung, über einen fünften Widerstand mit dem ersten Knotenpunkt und über eine Klemmdiode mit einem Versorgungspotential gekoppelt sein. Entsprechend kann der Eingang des ersten Inverters sowie der erste Eingang des ersten NAND-Gatters über einen sechsten Widerstand mit dem zweiten Anschluß der Sekundärwicklung, über einen siebten Widerstand mit dem zweiten Knotenpunkt und über eine weitere Klemmdiode mit dem Versorgungspotential gekoppelt sein.

Außerdem kann vorgesehen werden, daß der Magnetkern zusätzlich eine Kompensationswicklung aufweist, die durch eine Auswerteschaltung mit einem Kompensationsstrom angesteuert wird, der seinerseits aus einem Signal der Sekundärwicklung hergeleitet wird. Die Auswerteschaltung enthält dabei bevorzugt eine Brückenverstärkerschaltung, die mit einem pulsweitenmodulierten Signal angesteuert wird. Aufgrund der Brückenverstärkerschaltung ist ein Betrieb bei kleinen, unipolaren Versorgungsspannungen gewährleistet und aufgrund des getakteten Betriebs der Brückenverstärkerschaltung mittels des pulsweitenmodulierten Signals ergibt sich eine sehr geringe Verlustleistung.

Schließlich wird bei einer sehr aufwandsarmen Ausführungsform die Sekundärwicklung in Reihe zu einem Widerstand liegend zwischen Eingang und Ausgang eines Schmitt-Triggers geschaltet.

Bei den erfindungsgemäßen Stromsensoren ist es darüber hinaus möglich, bei einer Ansteuerung mit dreieckförmigem Strom die entstehenden Spannungspulse oder den Strom während des Spannungsmaximums an der Spule auszuwerten.

Die Erfindung wird nachfolgend anhand der in den Figuren der Zeichnung dargestellten Ausführungsbeispiele näher erläutert, wobei gleiche Elemente mit gleichen Bezugszeichen versehen sind. Es zeigt:
Figur 1 eine erste Ausführungsform,
Figur 2 eine zweite Ausführungsform,
Figur 3 eine dritte Ausführungsform und
Figur 4 eine vierte Ausführungsform eines erfindungsgemäßen Stromsensors.

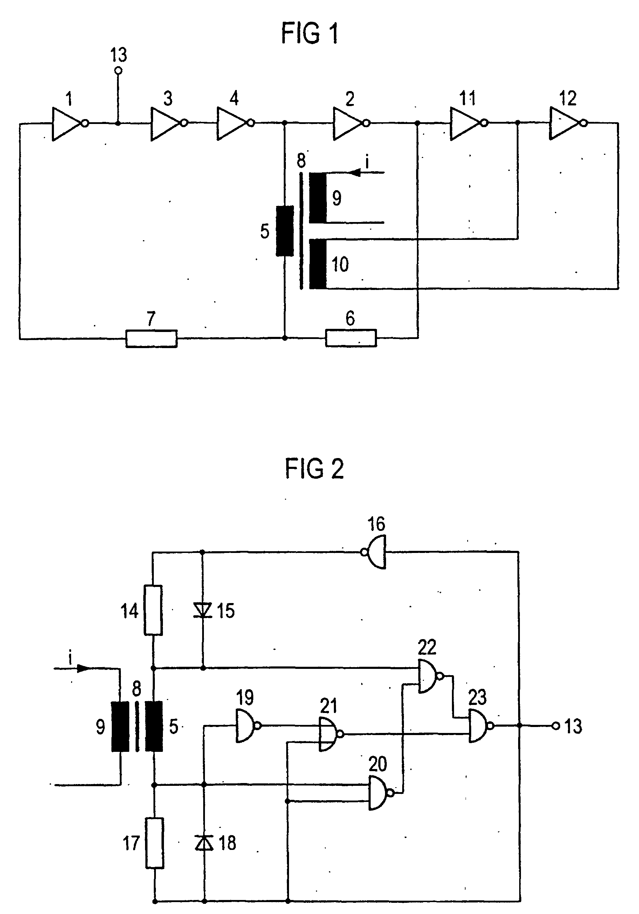

Bei dem Ausführungsbeispiel nach Figur 1 sind zwei invertierende Verstärker 1, 2 mit sehr hoher Verstärkung (wie beispielsweise auch Komparatoren, logische Inverter, Schaltverstärker, Schmitt-Trigger etc.) in Reihe zueinander geschaltet. Um das Schaltverhalten des Verstärkers 1 weiter zu Verbessern, sind diesem zwei weitere Verstärker 3 und 4 nachgeschaltet, so daß auf den Verstärker 1 der Verstärker 3, der Verstärker 4 und schließlich der Verstärker 2 folgen. An den Knotenpunkt von Verstärker 4 und Verstärker 2 ist ein Anschluß einer Sekundärwicklung 5 angeschlossen, deren anderer Anschluß über einen Widerstand 6 mit dem Ausgang des Verstärkers 2 und über einen Widerstand 7 mit dem Eingang des Verstärkers 1 verbunden ist. Die Sekundärwicklung 5 ist auf einen weichmagnetischen Magnetkern 8 aufgewickelt, auf den auch eine von einem zu messenden Strom i durchflossene Primärspule 9 aufgebracht ist.

Aufgrund ihrer hohen Verstärkung wirken die Verstärker 1 bis 2 wie Komparatoren und weisen daher eine bestimmte Schaltschwelle auf, oberhalb derer sie einen bestimmten ersten Signalpegel am Ausgang führen und unterhalb derer sie einen bestimmten zweiten Signalpegel am Ausgang bereitstellen. Je nach Stärke des in der Sekundärwicklung 5 fließenden Stromes führt der Ausgang des Verstärkers 1 den ersten oder zweiten Signalpegel. Dieser Signalpegel wird von den darauffolgenden Verstärkern 3 und 4 jeweils invertiert und die Steilheit der Umschaltflanken jeweils erhöht. Der Widerstand 7 dient dabei zur Eingangsstrombegrenzung für den Verstärker 1. Damit liegt beispielsweise an dem einen Anschluß der Sekundärwicklung 5 der erste Signalpegel an und aufgrund der Invertierung durch den Verstärker 2 der zweite Signalpegel. Der Widerstand 6 dient dabei zur Ausgangsstrombegrenzung des Verstärkers 2. Erreicht nun der Strom in der Sekundärwicklung 5 einen bestimmten Wert, so kippt der Verstärker 1 wiederum und die Pegelverhältnisse an der Sekundärwicklung 5 kehren sich um.

In Weiterbildung der Erfindung ist auf den Magnetkern 8 zudem eine Kompensationswicklung 10 aufgewickelt, deren einer Anschluß mit dem Ausgang eines invertierenden Verstärkers 11 und dessen anderer Anschluß mit dem Ausgang eines invertierenden Verstärkers 12 verbunden ist. Der Eingang des Verstärkers 12 ist dabei an den Ausgang des Verstärkers 11 angeschlossen, dessen Eingang wiederum mit dem Ausgang des Verstärkers 2 verschaltet ist. An den Ausgängen der Verstärker 1 bis 4 stehen jeweils pulsweitenmodulierte Singale bereit, deren Pulsweitenverhältnis zu dem zu messenden Strom i proportional sind. Beim vorliegenden Ausführungsbeispiel wird der Ausgang des Verstärkers 1 als Ausgang des gesamten Stromsensors vorgesehen, während der Ausgang des Inverters 2 zur Ansteuerung der beiden Verstärker 11 und 12 in Brückenschaltung dient.

Bei dem Ausführungsbeispiel nach Figur 2 ist ein Anschluß der Sekundärwicklung 5 über einen Widerstand 14, dem eine Freilaufdiode 15 parallel geschaltet ist, an den Ausgang eines Inverters 16 angeschlossen. Der Eingang des Inverters ist mit dem Ausgang 13 der Stromsensorschaltung verbunden. Der andere Anschluß der Sekundärwicklung 5 ist über einen Widerstand 17 und einer dazu parallel geschalteten Freilaufdiode 18 direkt an den Ausgang 13 angeschlossen. Der zweite Anschluß der Sekundärwicklung 5 ist zudem zum einem mit dem Eingang eines Inverters 19 und zum anderen mit einem Eingang eines NAND-Gatters 20 verschaltet. Der Ausgang des Inverters 19 ist seinerseits mit einem Eingang eines NOR-Gatters 21 gekoppelt. Der jeweils andere Eingang des NOR-Gatters 21 und des NAND-Gatters 20 sind mit dem Ausgang 13 verschaltet. Darüber hinaus ist ein NAND-Gatter 22 vorgesehen, dessen einer Eingang mit dem ersten Anschluß der Sekundärwicklung 5 und dessen anderer Eingang mit dem Ausgang des NAND-Gatters 20 verbunden ist. Die Ausgänge des NAND-Gatters 22 und des NOR-Gatters 21 sind auf die Eingänge eines AND-Gatters 23 geführt, dessen Ausgang den Ausgang 13 der Sensorschaltung bildet.

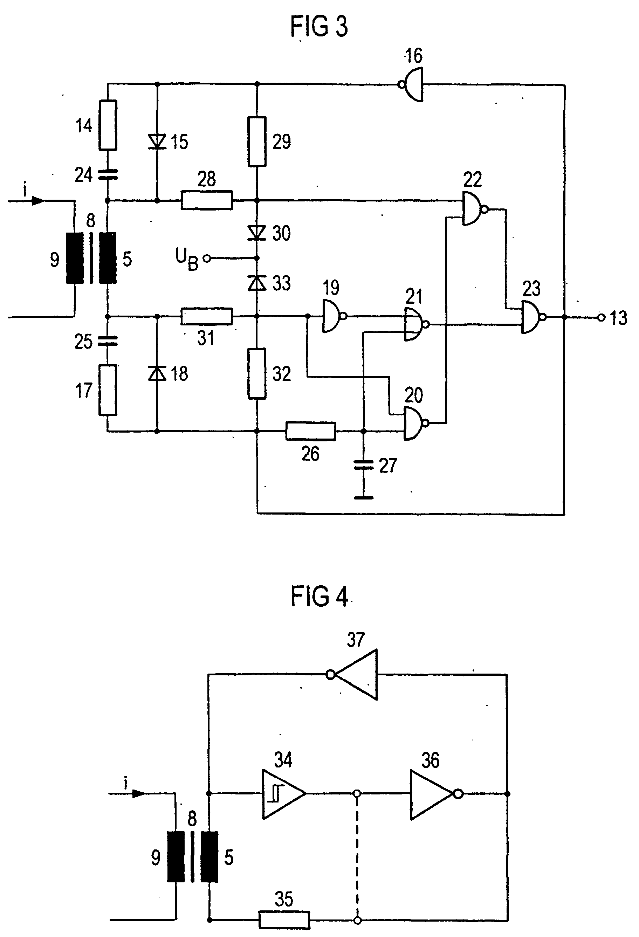

Das Ausführungsbeispiel nach Figur 3 ist gegenüber dem Ausführungsbeispiel nach Figur 2 dahingehend abgeändert, daß in Reihe zu den Widerständen 14 und 17 jeweils ein Kondensator 24 bzw. 25 geschaltet ist. Darüber hinaus ist dem zweiten Eingang des NAND-Gatters 20 ein Tiefpaß, bestehend aus dem seriell geschalteten Widerstand 26 und dem quergeschalteten, auf Masse führenden Kondensator 27, vorgeschaltet. Zwischen den ersten Anschluß der Sekundärwicklung 5 und den ersten Eingang des NAND-Gatters 22 ist ein Widerstand 28 geschaltet, wobei der Knotenpunkt aus Widerstand 28 und NAND-Gatter 22 zum einen über einen Widerstand 29 mit dem Ausgang des Inverters 16 und zum anderen über eine Klemmdiode 30 mit einem Versorgungspotential U_{B} verbunden. In gleicher Weise sind der Eingang des Inverters 19 sowie der erste Eingang des NAND-Gatters 20 über einen Widerstand 31 mit dem zweiten Anschluß der Sekundärwicklung 5, über einen Widerstand 32 mit dem zweiten Knotenpunkt und über eine Klemmdiode 33 mit dem Versorgungspotential U_{B} verbunden.

Bei der in Figur 4 gezeigten Ausführungsform besteht die Generatorschaltung im einfachsten Fall aus einem Schmitt-Trigger 34, wobei der eine Anschluß der Sekundärwicklung 5 an den Eingang des Schmitt-Triggers 34 angeschlossen ist und der andere Anschluß über einen Widerstand 35 mit dem Ausgang des Schmitt-Triggers gekoppelt ist. Diese einfache Form, die im übrigen in der Zeichnung als strichpunktierte Verbindung dargestellt ist, ist für den Betrieb mit bipolarer Spannungsversorgung vorgesehen. Steht dagegen nur eine unipolare Spannungsversorgung zur Verfügung, so ist vorgesehen, dem Schmitt-Trigger 34 zwei Verstärker, beispielsweise zwei invertierende Schaltverstärker 36 und 37 in Reihe, nachzuschalten. Dabei ist der Ausgang des Schmitt-Triggers 34 mit dem Eingang des Schaltverstärkers 36 verbunden, dessen Ausgang zum einen mit dem Eingang des Schaltverstärkers 37 und zum anderen über den Widerstand 35 mit dem zweiten Anschluß der Sekundärspule 5 gekoppelt ist. Der Ausgang des Schaltverstärkers 37 ist dabei auf den ersten Anschluß der Sekundärwicklung 5 und damit auch an den Eingang des Schmitt-Triggers 34 angeschlossen.

Ein Vorteil der Erfindung ist, daß die Realisierung eines Stromsensors für Ströme im mA-Bereich bis hin zum 100 A-Bereich, der nach dem Kompensationsprinzip arbeitet, ermöglicht wird, aber mit nur einer kombinierten Sensor- und Kompensationswicklung auskommt. Dabei können verschiedene Arten der Ansteuerung für den Magnetfelddetektor verwendet werden. In gleicher Weise können auch Ansteuerungen des Magnetfelddetektors für Kompensationsstromsensoren für Ströme im mA-Bereich bis hin zum 1000 A-Bereich bei getrennten Kernen und Wicklungen für Magnetfelddetektor und Kompensationswicklung realisiert werden. Schließlich sind auch Ausführungen möglich, bei denen unter. Verwendung verschiedener Ansteuerungen des Magnetfelddetektors bei Kompensationsstromsensoren für Ströme im mA-Bereich bis hin zum 100 A-Bereich mit gemeinsamem Kern und getrennten Wicklungen für Magnetfelddetektor und Kompensationswicklung verwendet werden.

Der Magnetfelddetektor besteht beispielsweise aus einem bewickelten Ringkern oder einem geschlossenen Kern beliebiger Form ohne oder mit sehr kleinem Luftspalt und sehr kleinem Querschnitt. Der Ringkern kann aber auch offen ausgeführt werden und erst zum Messen über einen Leiter geschlossen werden (Wäscheklammerprinzip). Die Bewicklung kann partiell erfolgen. Es können beispielsweise eine oder mehrere Lagenwicklungen aufgebracht werden und anschließend kann ein Kern hineingewickelt werden, der aus duktilem, amorphem, weichmagnetischem Band oder Draht besteht. Bevorzugt werden die erfindungsgemäßen Stromsensoren bei Kompensationsstromsensoren eingesetzt, wie sie beispielsweise in der europäischen Patentschrift EP 0 294 590 beschrieben sind.

Zur Detektion des Magnetfeldes wird die besondere Form der Magnetisierungsschleife des weichmagnetischen Kerns und die Tatsache ausgenutzt, daß diese Schleife linear mit dem Strom im Leiter verschoben wird, der vom weichmagnetischen Kern umschlossen ist. Zur Ansteuerung des Sensorelements (beispielsweise Sekundärwicklung) wird der weichmagnetische Kern mit einer Wechselaussteuerung beaufschlagt, die auch zyklisch durch Pulse erfolgen kann. Diese Aussteuerung geschieht mittels eines Sensorstromes in der Bewicklung. Durch die nichtlineare Kennlinie des Magnetwerkstoffes kann die Symmetrie abgefragt werden und damit festgestellt werden, ob der Magnetkern magnetisiert ist oder nicht. Bei einer Abweichung vom magnetischen Nullpunkt wird ein Kompensationsstrom erzeugt, der den Kern wieder in den Nullpunkt bringt. Durch entsprechende Filter muß dafür gesorgt werden, daß die Sensorabfrage nicht dem Ausgangssignal überlagert ist, das wiederum gleich dem Kompensationsstrom ist. Die Schleifenform, der Wert der Sättigung und mit Einschränkungen auch die Hysterese des Magnetstoffe sind dabei nur von untergeordneter Bedeutung.

Neben dem selbstschwingenden Sensorprinzip sind auch Prinzipien mit Wechselaussteuerung durch extern getriggerte Generatoren möglich. Bei durch einen Generator mit externer Triggerung fest vorgegebener Ansteuerfrequenz besteht die Möglichkeit, mit Wechselspannung (Sinus, Rechteck oder Sägezahn) oder mit Wechselstrom (Sinus oder Dreieck) anzusteuern. Je nach Anwendung kann dabei auch mit niedrigen Frequenzen (quasi getaktet) oder mit Einzelpulsen gearbeitet werden. So könnten beispielsweise bei Wechselspannungsansteuerung die Summe von positivem und negativem Spitzenstrom ausgewertet werden. Die Spitzenstromauswertung kann entweder durch eine sample-and-hold-Schaltung oder durch Aufladung von Kapazitäten über Dioden geschehen. Eine weitere Möglichkeit der Auswertung besteht in der Messung des Stroms in der Sensorwicklung während der Ummagnetisierung, die im kompensierten Fall gleich Null sein muß. Bei einer Ansteuerung durch Wechselstrom wird ebenfalls der Steuerstrom während der Ummagnetisierung ausgewertet. Hierbei ist der Zeitpunkt des ungefähren Nulldurchgangs der Magnetisierung durch das entstehende Spannungsmaximum an der Sensorwicklung leicht feststellbar und damit leicht auswertbar.

## Patentansprüche

1. Stromsensor mit einem Magnetkern (8), auf dem neben einer Primärwicklung (9), in der der zu messende Strom (i) fließt, mindestens eine Sekundärwicklung (5) aufgewickelt ist, in die ein durch eine selbstschwingende Generatorschaltung (1 bis 7; 14 bis 29) erzeugter Wechselstrom eingespeist wird, der den Magnetkern (8) abwechselnd in mindestens einer Richtung sättigt, wobei die Polarität des von der Generatorschaltung (1 bis 7; 14 bis 29) erzeugten Wechselstroms in Abhängigkeit von dem in der Sekundärwicklung (5) fließenden Strom und mindestens einem Schwellenwert für diesen Strom wechselt,
**dadurch gekennzeichnet, daß** die Generatorschaltung (1 bis 7; 14 bis 29) eine Reihenschaltung zweier invertierender Verstärker (1, 2, 16, 22) aufweist, daß die Sekundärwicklung (5) über einen ersten Widerstand (6, 14) zwischen Eingang und Ausgang des einen Verstärkers (2, 16) geschaltet ist und der Eingang des einen Verstärkers (2, 16) zudem mit dem Ausgang des anderen Verstärkers (1, 22) gekoppelt ist und daß an den Ausgang mindestens eines der beiden Verstärker (1, 2, 16, 22) ein dem zu messenden Strom (i) entsprechendes, pulsweitenmoduliertes Ausgangssignal (13) abgreifbar ist.

2. Stromsensor nach Anspruch 1,
**dadurch gekennzeichnet,**
**daß** bei der Generatorschaltung (1 bis 7; 14 bis 29) ein zweiter Widerstand (14) zwischen einen ersten Knotenpunkt und einen ersten Anschluß der Sekundärwicklung (5) und ein dritter Widerstand (17) zwischen einen zweiten Knotenpunkt und einen zweiten Anschluß der Sekundärwicklung (5) geschaltet ist, daß der zweite Anschluß der Sekundärwicklung (5) mit einem Eingang eines ersten NAND-Gatters (20) und unter Zwischenschaltung eines ersten Inverters (19) mit einem Eingang eines NOR-Gatters (21) verbunden ist, wobei jeweils ein zweiter Eingang von erstem NAND-Gatter (20) und NOR-Gatter (21) mit dem zweiten Knotenpunkt verschaltet sind, daß ein Eingang eines zweiten NAND-Gatters (22)mit dem ersten Anschluß der Sekundärwicklung (5) und dessen zweiter Eingang mit dem Ausgang des ersten NAND-Gatters (20) verbunden ist, und
**daß** die Ausgänge von NOR-Gatter (21) und erstem NAND-Gatter (20) mit den Eingängen eines zweiten NAND-Gatters (23) gekoppelt sind, dessen das pulsweitenmodulierte Ausgangssignal (13) führender Ausgang mit dem zweiten Knotenpunkt direkt und mit dem ersten Knotenpunkt unter Zwischenschaltung eines zweiten Inverters (16) verbunden ist.

3. Stromsensor nach Anspruch 2,
**dadurch gekennzeichnet, daß** jeweils zwischen erstem Knotenpunkt und erstem Anschluß der Sekundärwicklung (5) sowie zwischen zweitem Knotenpunkt und zweitem Anschluß der Sekundärwicklung (5) jeweils eine Freilaufdiode (15, 18) geschaltet ist.

4. Stromsensor nach Anspruch 2 oder 3,
**dadurch gekennzeichnet, daß** in Reihe zu zweitem und drittem Widerstand (14, 17) jeweils ein Kondensator ( 24, 25) geschaltet ist.

5. Stromsensor nach Anspruch 2, 3 oder 4,
**dadurch gekennzeichnet, daß** zwischen den zweiten Eingang des ersten NAND-Gatters (20) und den zweiten Knotenpunkt ein Tiefpaß (26, 27) geschaltet ist.

6. Stromsensor nach einem der Ansprüche 2 bis 5,
**dadurch gekennzeichnet, daß** auch ein Eingang des zweiten NAND-Gatters (23) über einen vierten Widerstand (28) mit dem ersten Anschluß der Sekundärwicklung (5), über einen fünften Widerstand (29) mit dem ersten Knotenpunkt und über eine Klemmdiode (30) mit einem Versorgungspotential (U_{B}) gekoppelt ist und daß der Eingang des ersten Inverters (19) sowie der erste Eingang des ersten NAND-Gatters (20) über einen sechsten Widerstand (31) mit dem zweiten Anschluß der Sekundärwicklung (5), über einen siebten Widerstand (32) mit dem zweiten Knotenpunkt und über eine weitere Klemmdiode (33) mit dem Versorgungspotential (U_{B}) gekoppelt sind.

7. Stromsensor nach Anspruch 1 und 2,
**dadurch gekennzeichnet, daß** die Sekundärwicklung (5) in Reihe zu einem siebten Widerstand (35) liegend zwischen Eingang und Ausgang eines Schmitt-Triggers (34) geschaltet ist.

8. Stromsensor nach einem der vorherigen Ansprüche,
**dadurch gekennzeichnet, daß** der Magnetkern (8) eine Kompensationswicklung (10) aufweist, die durch eine Auswerteschaltung (11, 12) mit einem Kompensationsstrom angesteuert wird, der aus einem Signal der Sekundärwicklung (5) hergeleitet ist.

9. Stromsensor nach Anspruch 8,
**dadurch gekennzeichnet, daß** die Auswerteschaltung eine Brückenverstärkerschaltung (11, 12) aufweist.

## Claims

1. Current sensor comprising a magnetic core (8) on to which, in addition to a primary winding (9) in which the current (i) to be measured flows, at least one secondary winding (5) is wound, to which an alternating current generated by a self-oscillating generator circuit (1 to 7; 14 to 29) is fed, saturating the magnetic core (8) alternately in at least one direction, the polarity of the alternating current generated by the generator circuit (1 to 7; 14 to 29) varying as a function of the current flowing in the secondary winding (5) and at least one threshold value for this current, **characterised in that** the generator circuit (1 to 7; 14 to 29) comprises two inverting amplifiers (1, 2, 16, 22) connected in series, that the secondary winding (5) is connected via a first resistor (6, 14) between the input and output of one amplifier (2, 16) and the input of one amplifier (2, 16) is additionally coupled to the output of the other amplifier (1, 22) and that a pulse width-modulated output signal (13) corresponding to the current (i) to be measured can be tapped off at the output of at least one of the two amplifiers (1, 2, 16, 22).

2. Current sensor according to claim 1, **characterised in that**, in the generator circuit (1 to 7; 14 to 29), a second resistor (14) is connected between a first node and a first terminal of the secondary winding (5) and a third resistor (17) is connected between a second node and a second terminal of the secondary winding (5), that the second terminal of the secondary winding (5) is connected to one input of a first NAND gate (20) and, with the interposition of a first inverter (18), to one input of a NOR gate (21), respective second inputs of the first NAND gate (20) and of the NOR gate (21) being connected to the second node, that one input of a second NAND gate (22) is connected to the first terminal of the secondary winding (5) and its second input is connected to the output of the first NAND gate (20) and that the outputs of the NOR gate (21) and the first NAND gate (20) are coupled to the inputs of a second NAND gate (23), the output of which carrying the pulse width-modulated output signal (13) is connected directly to the second node and, with the interposition of a second inverter(16), to the first node.

3. Current sensor according to claim 2, **characterised in that** respective freewheeling diodes (15, 18) are connected between the first node and the first terminal of the secondary winding (5) and between the second node and the second terminal of the secondary winding (5).

4. Current sensor according to claim 2 or claim 3, **characterised in that** respective capacitors (24, 25) are connected in series with the second and third resistors (14, 17).

5. Current sensor according to claim 2, 3 or 4, **characterised in that** a low-pass filter (26, 27) is connected between the second input of the first NAND gate (20) and the second node.

6. Current sensor according to one of claims 2 to 5, **characterised in that** one input of the second NAND gate (23) is also coupled via a fourth resistor (28) to the first terminal of the secondary winding (5), via a fifth resistor (29) to the first node and via a clamping diode (30) to a supply potential (U_{B}) and that the input of the first inverter (19) and the first input of the first NAND gate (20) are coupled via a sixth resistor (31) to the second terminal of the secondary winding (5), via a seventh resistor (32) to the second node and via a further clamping diode (33) to the supply potential (U_{B})

7. Current sensor according to claims 1 and 2, **characterised in that** the secondary winding (5) is connected in series with a seventh resistor (35) situated between the input and output of a Schmitt trigger (34).

8. Current sensor according to one of the preceding claims, **characterised in that** the magnetic core (8) comprises a compensating winding (10) driven by an evaluation circuit (11, 12) by a compensating current derived from a signal of the secondary winding (5).

9. Current sensor according to claim 8, **characterised in that** the evaluation circuit comprises a bridge amplifier circuit (11,12).

## Revendications

1. Capteur de courant comportant un noyau magnétique (8) portant à côté d'un enroulement primaire (9) traversé par le courant i à mesurer, au moins un enroulement secondaire (5) recevant un courant alternatif généré par un générateur auto-oscillant (1-7 ; 14-29), qui sature le noyau magnétique (8) alternativement dans au moins une direction, la polarité du courant alternatif généré par le générateur (1-7 ; 14-29) changeant en fonction du courant passant dans l'enroulement secondaire (5) et d'au moins un seuil pour ce courant,
**caractérisé en ce que**
le générateur (1-7 ; 14-29) comporte un montage en série formé de deux amplificateurs inverseurs (1, 2, 16, 22),
l'enroulement secondaire (5) est branché par une première résistance (6) entre l'entrée et la sortie dans l'amplificateur (2, 16), et l'entrée d'un amplificateur (2, 16) est couplée en outre à la sortie de l'autre amplificateur (1, 22), et
la sortie d'au moins l'un des deux amplificateurs (1, 2, 16, 22) donne un signal de sortie (13) modulé en largeur d'impulsion, correspondant au courant (i) à mesurer.

2. Capteur de courant selon la revendication 1,
**caractérisé en ce que**
le générateur (1-7; 14-29) comporte une seconde résistance (14) entre un premier noeud et un premier branchement de l'enroulement secondaire (5) et une troisième résistance (17) entre un second noeud et un second branchement de l'enroulement secondaire (5),
un second branchement de l'enroulement secondaire (5) étant relié à une entrée d'une première porte NON-ET (20) et à une entrée d'une porte d'entrée NON-OU (21), chaque fois une seconde entrée de la première porte NON-ET (20) et de la porte NON-OU (21) étant reliée au second noeud avec interposition d'un premier inverseur (19),
une entrée d'une seconde porte NON-ET (22) est reliée au premier branchement de l'enroulement secondaire (5) et sa seconde entrée est reliée à la sortie de la première porte NON-ET (20), et
les sorties de la porte NON-OU (21) et de la première porte NON-ET (20) sont reliées aux entrées d'une seconde porte NON-ET (23) dont la sortie conduisant le signal de sortie (13) modulé en largeur d'impulsion est reliée directement au second noeud et par l'intermédiaire d'un second inverseur (16) au premier noeud.

3. Capteur de courant selon la revendication 2,
**caractérisé en ce que**
chaque fois entre un premier noeud et un premier branchement de l'enroulement secondaire (5) ainsi qu'entre un second noeud et un second branchement de l'enroulement secondaire (5), on a une diode de roue libre (15, 18).

4. Capteur de courant selon la revendication 2 ou 3,
**caractérisé en ce qu'**
en série avec la seconde et la troisième résistance (14, 17) on a chaque fois un condensateur (24, 25).

5. Capteur de courant selon les revendications 2, 3, ou 4,
**caractérisé en ce qu'**
entre la seconde rentrée de la première porte NON-ET (20) et un second noeud on a un filtre passe-bas (26, 27).

6. Capteur de courant selon l'une quelconque des revendications 2 à 5,
**caractérisé en ce qu'**
une entrée de la seconde porte NON-ET (23) est également reliée par une quatrième résistance (28) au premier branchement du secondaire (5), par une cinquième résistance (29) au premier noeud et par une diode de blocage (30) à un potentiel d'alimentation U_{B}, et
l'entrée du premier inverseur (19) ainsi que la première entrée de la première porte NON-ET (20) sont reliées par une sixième résistance (31) au second branchement de l'enroulement secondaire (5), par une septième résistance (32) au second noeud et par une autre diode de blocage (33) au potentiel d'alimentation U_{B}.

7. Capteur de courant selon les revendications 1 et 2,
**caractérisé en ce que**
l'enroulement secondaire (5) est branché en série avec une septième résistance (35) placée entre l'entrée et la sortie d'un déclencheur de Schmitt (34).

8. Capteur de courant selon l'une des revendications précédentes,
**caractérisé en ce que**
le noyau magnétique (8) comporte un enroulement de compensation (10) commandé par un circuit d'exploitation (11, 12) avec un courant de compensation provenant d'un signal de l'enroulement secondaire (5).

9. Capteur de courant selon la revendication 8,
**caractérisé en ce que**
le circuit d'exploitation comporte un montage en pont amplificateur (11, 12).
